# EUROPEAN PATENT SPECIFICATION

(11) **EP 1 795 624 B1**
(45) Date of publication and mention of the grant of the patent: **25.04.2012**
(21) Application number: 05770381.1
(22) Date of filing: 09.08.2005
(51) Int. Cl.: C23C 14/24, C01B 33/037, C01B 33/113

(54) **SiO DEPOSITION MATERIAL**
SIO-ABSCHEIDUNGSMATERIAL
MATIÈRE DE DÉPÔT DE SiO

(30) Priority: 01.09.2004 JP 2004253771
(43) Date of publication of application: 13.06.2007
(73) Proprietor: OSAKA Titanium Technologies Co., Ltd., Amagasaki-shi, Hyogo 660-8533 (JP)
(72) Inventor: NISHIOKA, Kazuo, cho, Amagasaki-shi, Hyogo 6608533; (JP); KIZAKI, Shingo, cho, Amagasaki-shi, Hyogo 6608533; (JP)
(74) Representative: Simons, Amanda Louise
(86) International application number: PCT/JP2005/014554
(87) International publication number: WO 2006/025195

(56) References cited:
- FR-A- 2 557 556
- JP-A- 2002 069 618
- JP-A- 2004 076 120
- JP-A- 2004 525 841
- US-A- 5 037 503
- US-A1- 2003 150 377
- ODDEN J O ET AL: "From monosilane to crystalline silicon. Part III. Characterization of amorphous, hydrogen-containing silicon products" JOURNAL OF NON-CRYSTALLINE SOLIDS, NORTH-HOLLAND PHYSICS PUBLISHING. AMSTERDAM, NL, vol. 351, no. 14-15, 15 May 2005 (2005-05-15), pages 1317-1327, XP004884257 ISSN: 0022-3093
- ECKERT H-J ET AL: "WISSENSCHAFTLIUHE ZEITSURHRIFT//UNTERSUCHUNGEN AN SILICIUMOXIDEN" TECHNISCHE HOCHSCHULE KARL-MARX STADT. WISSENSCHAFTLICHEZEITSCHRIFT, TECHNISCHE UNIVERSITAET CHEMNITZ, DE, vol. 18, no. 1, 1 January 1976 (1976-01-01), pages 103-112, XP008004244 ISSN: 0372-7610

## Description

### Technical Field

The present invention relates to a silicon monoxide vapor deposition material, a silicon powder as a raw material thereof, and a method for producing the silicon monoxide vapor deposition material, the silicon monoxide vapor deposition material being capable of suppressing a splash generated in vapor-depositing and being used as packaging materials having both transparency and barrier properties in the fields such as foods, medical products, and medicinal products

### Background Art

Usually, in the case where foods and the like are packaged in the field of the food processing industry, oxygen, hydrogen, aromatic gas, and the like permeate the packaging materials to oxidize fats and fatty oils, vitamins, and proteins. Therefore, sometimes nutrition components are decreased to cause foods deterioration such as color fading and discoloration or degradation of flavor and absorption of off-flavor. Thus, in the field of the food processing industry, in order to prevent the deterioration of the fats and fatty oils, proteins, and the like, gas barrier properties are demanded for the packaging materials such that the oxygen, moisture, and the like do not penetrate the packaging materials. Further, in the field in which medical products and medicinal products are dealt with, a high standard against the deterioration or degeneration is set with respect to the medical products and medicinal products, and the high gas barrier properties are demanded for the packaging materials.

Conventionally, the packaging material having aluminum foil or aluminum vapor-deposited film is used as the packaging material having the high gas barrier properties. However, there are many problems in the conventional packaging materials. That is, aluminum in the packaging material is eluted to easily damage an incinerator in a combustion disposal process. In recycling the packaging materials, it is difficult to separate the aluminum component from a resin film or paper which is of a substrate base. Furthermore, because of the opaque packaging materials, the deterioration or degeneration of inside contents cannot sufficiently be confirmed.

Recently, attention is being paid to the packaging materials formed by the silicon monoxide vapor-deposited film having both the high gas-barrier properties and the excellent transparency. As used herein, the term "silicon monoxide vapor-deposited film" shall mean a silica vapor-deposited film, and when a composition of the silicon monoxide vapor-deposited film is expressed by SiOₓ, a value of suffix "x" is in a range of 1<x<2. Preferably the value of x is set in the range of 1.4<x<1.8 when the silicon monoxide vapor-deposited film is utilized for the purpose of a gas-barrier in the packaging material.
The term "transparency" shall generally mean that, when the silicon monoxide vapor-deposited film is deposited on a transparent resin film to produce the packaging material, the silicon monoxide vapor-deposited film has no influence on light transmission and packaged contents can clearly be observed. Therefore, the transparency is an essential feature for the packaging materials.

Usually, a mixture of silicon and silicon dioxide is heated, a silicon monoxide gas sublimated from the mixture is deposited as a silicon monoxide lump on a deposition substrate base, and thereby the vapor deposition material which can form the foregoing silicon monoxide vapor-deposited film is produced by performing forming such as crushing or grinding to the deposited silicon monoxide.
H.J. Eckert and H. König, in "Untersuchungen an Siliciumoxiden", Wiss. Z. d. Techn. Hochsch. Karl-Marx-Stadt 18 (1976) 103-112, show the use of silicon and silicon oxide mixtures to obtain silicon monoxides.
US 2003/0150377 A1 discloses high-purity silicon monoxide vapor deposition material by mixing metallic silicon powder and silicon dioxide powder and heat-treat the mixture before vaporisation.

However, sometimes a splash is generated when a silicon monoxide vapor-deposited film is formed on a polymer film with the silicon monoxide vapor deposition material. The splash is a phenomenon in which not-sublimated high-temperature fine particles fly apart along with the sublimated silicon monoxide gas, and the splash phenomenon causes defects such as a pin hole to be generated to worsen the gas barrier properties when the fine particles adhere to the silicon monoxide vapor-deposited film on the polymer film.

Therefore, conventionally various improvements are made. For example, Japanese Patent Application Publication No. 2002-97567 proposes a silicon monoxide vapor deposition material and a producing method thereof, which has properties such as high bulk density and high hardness such that splash phenomenon can be suppressed in vapor-depositing the silicon monoxide on the substrate base. According to the producing method proposed by Japanese Patent Application Publication No. 2002-97567, a producing apparatus includes a raw material chamber and a deposition chamber. In the raw material chamber, the mixture of metallic silicon (Si) and a silicon oxide powder, whose molar ratio is set at 1:1 while having an average particle size of 10 µm, or alternatively a solid-state silicon monoxide, is heated and vaporized. In the deposition chamber, a gaseous silicon monoxide is deposited on the deposition substrate base. The raw material chamber is kept at a predetermined temperature lower than a sublimation temperature of the silicon monoxide, the temperature is raised to sublimate the silicon monoxide after a de-gassing process, and thereby the silicon monoxide is deposited on the deposition substrate base.

However, in the producing method proposed by Japanese Patent Application Publication No. 2002-97567, it is necessary to decrease a sublimation speed, because the silicon monoxide vapor deposition material has the high bulk density and high hardness when the mixture of the silicon powder and the silicon oxide powder is sublimated to deposit the silicon monoxide on the substrate base. Therefore, productivity becomes worsened, which results in a problem that production cost is increased for the silicon monoxide vapor deposition material.

### Disclosure of the Invention

It is an object of the present invention to provide a silicon monoxide vapor deposition material being capable of suppressing the splash phenomenon, when the packaging material having the silicon monoxide vapor-deposited film, which can secure the transparency that is of the feature of the silicon monoxide vapor-deposited film and has excellent gas barrier properties, is produced.

The present inventors perform various experiments concerning a behavior of vapor deposition of the silicon monoxide vapor deposition material to solve the above problem and find that the splash is intensely generated in vapor-depositing the silicon monoxide vapor-deposited film on the substrate base when a hydrogen gas concentration contained in the silicon monoxide vapor deposition material is increased. The present inventors also find that the hydrogen gas content of the metallic silicon powder as the raw material (a silicon powder as the raw material for silicon monoxide vapor deposition material) has a large influence on the hydrogen gas content of the silicon monoxide vapor deposition material in the production of the silicon monoxide vapor deposition material.

The present invention is completed based on the above findings, and the present invention includes the silicon monoxide vapor deposition material as described in claim 1.

According to the silicon monoxide vapor deposition material of the present invention, in vapor-depositing silicon monoxide on the substrate base, the splash phenomenon can be suppressed by lowering the hydrogen gas concentration contained in the silicon monoxide vapor deposition material. Furthermore, the silicon monoxide vapor deposition material having the small hydrogen gas content can efficiently be produced using the silicon powder as a raw material of the present invention.

### Brief Description of the Drawings

Fig. 1 shows a configuration example of a producing apparatus used in a method for producing a silicon monoxide powder of the present invention; and
Fig. 2 shows a relationship between a hydrogen gas content in a silicon monoxide vapor deposition material and a frequency number of generated splashes.

### Best Mode for Carrying out the Invention

The term of "splash phenomenon" used herein shall mean that, as described above, the high-temperature fine particles that are not sublimated fly apart along with the sublimated silicon monoxide gas due to the characteristics of the silicon monoxide vapor deposition material. The fine particles adhere to the silicon monoxide vapor-deposited film on the polymer film, which causes the defects such as the pin hole to be generated to worsen the gas barrier properties.

The frequency number of generated splashes is measured to quantitatively evaluate "splash phenomenon." The frequency number of generated splashes is the frequency number of splashes generated when the silicon monoxide vapor deposition material is irradiated for a predetermined time with an electron beam (hereinafter abbreviated to "EB") in vapor-depositing the silicon monoxide on the substrate base using an ion plating apparatus.

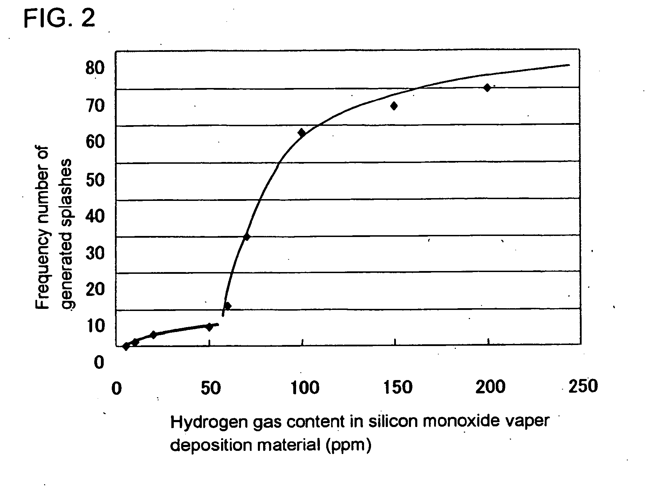

The silicon monoxide vapor deposition material, the silicon powder as the raw material thereof, and the method for producing the silicon monoxide vapor deposition material will be described below.
With reference to a relationship between the hydrogen gas content in the silicon monoxide vapor deposition material and the frequency number of generated splashes in vapor-depositing the silicon monoxide vapor deposition material on the substrate base, as shown in the after-mentioned Example and Fig. 2, usually the splash generation can significantly be suppressed by decreasing the hydrogen gas content contained in the silicon monoxide vapor deposition material.

That is, when the conventional silicon monoxide vapor deposition material and the silicon monoxide vapor deposition material of the present invention are compared in the frequency number of generated splashes, because the hydrogen gas content exceeds 50 up to 120 ppm in the conventional silicon monoxide vapor deposition material, the frequency number of generated splashes exceeds 10 and is up to about 60. On the other hand, the hydrogen gas content is not more than 50 ppm in the silicon monoxide vapor deposition material of the present invention, so that the frequency number of generated splashes can be decreased to 10 or less.

In this case, for the frequency number of generated splashes in vapor-depositing the silicon monoxide vapor deposition material on the substrate base, a sample having a diameter of 19 mm and a length of 20 mm is prepared by cutting out of the silicon monoxide vapor deposition material, and the frequency number of generated splashes is measured when the silicon monoxide vapor deposition material is irradiated for 60 seconds using the ion plating apparatus under the conditions of an EB output of 300W and an initial pressure of 4 × 10⁻⁴ Pa.

For the hydrogen gas content of the silicon powder which becomes the raw material, the hydrogen gas content exceeds 10 ppm up to 30 ppm in the conventional silicon powder. On the other hand, in the silicon powder as the raw material for the material of the present invention, it is necessary that the hydrogen gas content be not more than 10 ppm.
In other words, when the silicon monoxide vapor deposition material is produced with the silicon powder as the raw material whose hydrogen gas content is not more than 10 ppm, the hydrogen gas content of the silicon monoxide can become 50 ppm or less after the production. In this case, in order to produce the homogeneous silicon monoxide vapor deposition material, it is desirable that the hydrogen gas content of silicon powder as the raw material be not more than 5 ppm.

The present invention does not particularly limit a particle size of the silicon powder as the raw material, and the particle size usually used may be adopted. Nonetheless, desirably the average particle size ranges from 1 to 40 µm. More desirably the average particle size is not more than 10 µm. When the silicon powder as the raw material is processed to a fine powder, in performing the vacuum de-gassing process, a variation in concentration of the hydrogen gas is decreased in the particle of powders and a processing time can effectively be shortened.

In the measurement of the hydrogen gas content of the silicon monoxide or silicon powder of the present invention, after drying the sample, the sample is measured at a temperature increase rate of 0.5 °C/sec with a temperature-programmed desorption gas analysis apparatus (TDS) by a mass fragment method.

As described above, in the method for producing the silicon monoxide vapor deposition according to the present invention, a silicon powder and a silicon dioxide powder, of which each constitutes a raw material, are mixed together at a molar ratio of 1:1, the silicon powder being degassed to lower the hydrogen gas thereof and the raw materials which are dried after mixing and granulation are loaded in a raw material vessel of the producing apparatus: then, the raw materials are heated and sublimated in a vacuum: the sublimated gaseous silicon monoxide is deposited on the deposition substrate base: and the obtained deposited silicon monoxide is shaped by cutting and grinding to produce the silicon monoxide vapor deposition material.

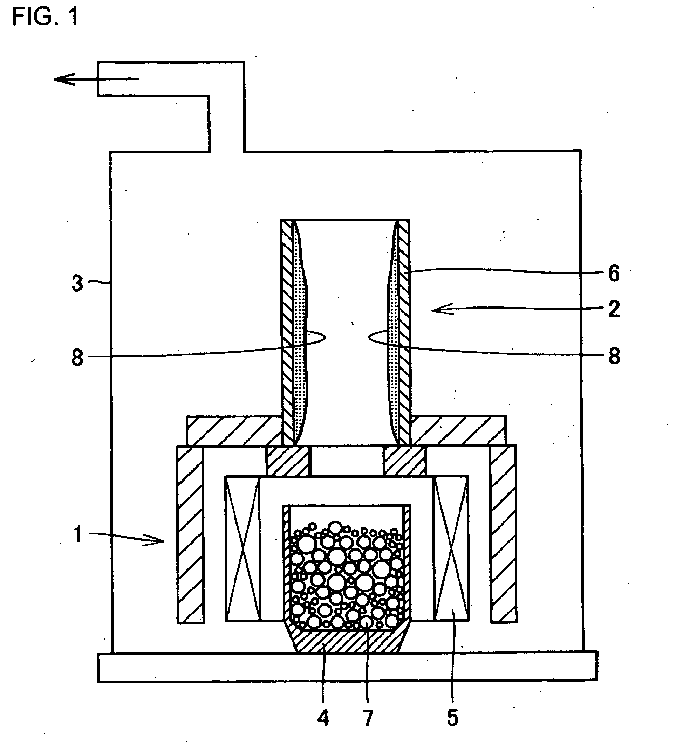

Fig. 1 shows a configuration example of the producing apparatus used in producing the silicon monoxide of the present invention. In the configuration of the producing apparatus, a deposition chamber 2 is disposed above and combined with a raw material chamber 1, both of which are installed in a vacuum chamber 3. In the above raw material chamber 1, a cylindrical raw material vessel 4 is placed in the center of the cylindrical body, and the peripheral region thereof is arranged to have, for instance, a heat source 5 made of an electric heater. A vacuum instrument or the like (not shown) is provided in the above vacuum chamber 3, the vacuum chamber 3 is evacuated or vacuum-pumped in an arrow direction shown in Fig. 1, and thereby the pressure is reduced.
A stainless steel vapor deposition substrate base 6 is provided in the above deposition chamber 2, and the gaseous silicon monoxide sublimated in the raw material chamber 1 is deposited on an inner peripheral surface of the cylindrical vapor deposition substrate base 6.

In the production apparatus shown in Fig. 1, a raw material (hereinafter referred to as "mixed granulation raw material") 7 in which the silicon powder or silicon fine powder, either of which is degassed to reduce the hydrogen gas thereof, and the silicon dioxide powder are mixed and granulated, is loaded in the raw material vessel 4, the raw material vessel 4 is heated in a vacuum, and the silicon monoxide is generated and sublimated by a reaction. The generated gaseous silicon monoxide rises from the raw material chamber 1 into the deposition chamber 2, and the gaseous silicon monoxide is vapor-deposited on the inner peripheral surface of the deposition substrate base 6 to form the deposited silicon monoxide 8. Then, the deposited silicon monoxide 8 is taken out from the apparatus, and the deposited silicon monoxide 8 is shaped to yield the silicon monoxide or the silicon monoxide vapor deposition material.
A level of vacuum in the production apparatus is not particularly limited, and the condition usually used in producing the silicon monoxide vapor deposition material may be adopted.

With reference to the conditions of the temperature increase, heating, and sublimation, as with the usual silicon monoxide vapor deposition material producing conditions, the mixed granulation raw material 7 loaded in the raw material vessel 4 of the production apparatus is heated from a room temperature to temperatures ranging from 800 to 1200 °C and kept at the temperature for two hours or more in order to dry and degas the mixed granulation raw material 7. Then, the mixed granulation raw material 7 is heated to temperatures ranging from 1100 to 1350 °C and vaporized, i.e., sublimated, and the gaseous silicon monoxide is deposited on the deposition substrate base which is maintained at temperatures ranging from 200 to 600 °C. In the deposited silicon monoxide obtained in the above manner, the silicon monoxide vapor deposition material having low hydrogen gas content can be produced.

In this producing method, the silicon monoxide vapor deposition material whose hydrogen gas content is not more than 50 ppm can be obtained by heating and vaporizing the mixed granulation raw material 7 composed of the silicon powder and silicon dioxide powder, said silicon powder having the hydrogen gas content of not more than 10 ppm. According to this producing method, the hydrogen gas content of the obtained silicon monoxide is higher than that of the silicon powder as the raw material. This is because the hydrogen gas contained in the silicon powder is detained by high bonding strength of the silicon with the hydrogen. As described above, the hydrogen gas content of the silicon powder and the hydrogen gas content of the obtained silicon monoxide can be measured with the temperature-programmed desorption gas analysis apparatus (TDS).

Fig. 2 shows a relationship between the hydrogen gas content in the silicon monoxide vapor deposition material and the frequency number of generated splashes. As shown in Fig. 2, when the hydrogen gas content of the silicon monoxide vapor deposition material is not more than 50 ppm, the frequency number of generated splashes is remarkably suppressed compared with the silicon monoxide vapor deposition material whose hydrogen gas content exceeds 50 ppm.

Even in the conventional silicon monoxide vapor deposition material, the frequency number of generated splashes ranges from about 11 to about 60 when the hydrogen gas concentration ranges from 60 to 110 ppm, while the frequency number of generated splashes ranges from about 60 to about 80 when the hydrogen gas concentration is not less than 120 ppm.

The silicon powder as the raw material for the materiel of the present invention in which the hydrogen gas is degassed is obtained by applying the heat treatment at temperatures not less than 700 °C for three hours or more in a vacuum to the silicon powder which is formed by mechanically crushing a high-purity silicon wafer and further pulverizing the high-purity silicon wafer with a ball mill or the like, or alternatively to a commercially available silicon powder. The hydrogen gas content can be controlled by the level of vacuum, heating temperature, and holding time.

Thus, the silicon monoxide vapor deposition material whose hydrogen gas concentration is lowered, the silicon powder as the raw material for the silicon monoxide vapor deposition material, and the method for producing the silicon monoxide vapor deposition material of the present invention are described. Alternatively, a method for degassing the hydrogen gas from the silicon in the mixed granulation raw material which is of the raw material of the conventional silicon monoxide vapor deposition material may be used as the method for producing the silicon monoxide vapor deposition material. A method for using the conventional mixed granulation raw material to degas the hydrogen gas during a process of producing the silicon monoxide may also be used.

### Example

The effect exhibited by the silicon monoxide vapor deposition material of the present invention will be described below by Example.
The high-purity silicon wafer is mechanically crushed to obtain the silicon powder whose average particle size is not more than 10 µm. The heat treatment is performed in a vacuum not more than 40 Pa to the silicon powder at temperatures not less than 700 °C for three hours or more, or the heat treatment is performed in an Ar gas atmosphere containing the hydrogen gas at temperatures in a range of 500 to 600 °C. As such, the silicon powders having the different hydrogen gas contents are produced.

The produced silicon powder is mixed and granulated with the silicon dioxide powder whose average particle size is not more than 10 µm to form the mixed granulation raw material, and the mixed granulation raw material loaded in the raw material vessel was heated to temperatures in a range of 1100 to 1350 °C and sublimated to deposit the silicon monoxide on the deposition substrate base with the silicon monoxide producing apparatus shown in Fig. 1. Then, the obtained silicon monoxide is shaped by pulverizing and grinding to form the silicon monoxide vapor deposition material as for a test sample.

Eight types of the silicon monoxide vapor deposition material (Inventive Example: four types and Comparative Example: four types) were prepared as the test samples, and the silicon monoxide vapor deposition material is vapor-deposited on a resin film with the ion plating apparatus, and the frequency number of generated splashes is measured at that time. As described above, the frequency number of generated splashes is measured when the silicon monoxide vapor deposition material is irradiated for 60 seconds using the ion plating apparatus under the conditions of the EB output of 300W and the initial pressure of 4 × 10⁻⁴ Pa.

Table 1 shows a relationship between the hydrogen gas content in the silicon monoxide vapor deposition material and the frequency number of generated splashes measured. As can be seen from the result of Table 1, when compared with the silicon monoxide vapor deposition material of Comparative Example of which each hydrogen gas content ranges from 60 to 200 ppm, the frequency number of generated splashes is dramatically decreased by securing the hydrogen gas content to be 50 ppm or less in Inventive Example. Furthermore, in the silicon monoxide vapor deposition material of Comparative Example, the frequency number of generated splashes is increased when the hydrogen gas content becomes high.

[Table 1]

**Table 1**

| Segment | Hydrogen gas content of silicon monoxide vapor deposition material (ppm) | Frequency number of generated splashes |
|---|---|---|
| Comparative Example | 60 | 11-20 |
| | 70 | 30 |
| | 150 | 65 |
| | 200 | 70 |
| Inventive Example | 50 | 5 |
| | 20 | 3 |
| | 10 | 1 |
| | 5 | 0 |

### Industrial Applicability

According to the silicon monoxide vapor deposition material of the present invention, the splash generation can be suppressed by lowering the hydrogen gas content to 50 ppm or less when the silicon monoxide is vapor-deposited on the substrate base, so that the silicon monoxide vapor-deposited film having the excellent transparency and barrier properties can be formed. And according to the silicon powders as the raw materials of the present invention, the silicon monoxide vapor deposition material in which the hydrogen gas content is lowered can efficiently be produced. Therefore, the silicon monoxide deposition material of the present invention can widely be used for producing the vapor deposition materials for the packaging materials having transparency and barrier properties which are used for foods, medical products, medicinal products, and the like.

## Claims

1. A silicon monoxide vapor deposition material comprising silicon monoxide and containing hydrogen gas in an amount of 5 to 50 ppm; wherein the hydrogen gas content is as measured at a temperature increase rate of 0.5°C/sec with a temperature-programmed desorption gas analysis apparatus (TDS) by a mass fragment method, after drying.

## Patentansprüche

1. Siliziummonoxiddampfabscheidungsmaterial, welches Siliziummonoxid umfasst und Wasserstoffgas in einer Menge von 5 bis 50 ppm enthält; wobei der Wasserstoffgasanteil nach Trocknen bei einer Temperaturanstiegsrate von 0,5°C/s mit einer temperaturprogrammierten Desorptionsgasanalysevorrichtung (TDS) durch ein Massenfragmentverfahren gemessen wird.

## Revendications

1. Matériau de dépôt en phase vapeur de monoxyde de silicium comportant du monoxyde de silicium et contenant du gaz d'hydrogène selon une quantité de 5 à 50 ppm, dans lequel le contenu de gaz d'hydrogène est tel que mesuré à une vitesse d'augmentation de température de 0,5°C/s à l'aide d'un appareil d'analyse de gaz de désorption à température programmée (TDS) par un procédé de fragments de masse, après séchage.
